Europäisches Patentamt

European Patent Office

Office européen des brevets

(19)

(11) Veröffentlichungsnummer: **0 123 729**
**A1**

(12) **EUROPÄISCHE PATENTANMELDUNG**

(21) Anmeldenummer: **83112604.0**

(22) Anmeldetag: **15.12.83**

(51) Int. Cl.³: **G 01 W 1/04, H 05 K 11/00**

(30) Priorität: **27.04.83 DE 3315188**

(43) Veröffentlichungstag der Anmeldung: **07.11.84**
**Patentblatt 84/45**

(84) Benannte Vertragsstaaten: **AT BE CH DE FR GB LI**

(71) Anmelder: **GRUNDIG E.M.V. Elektro-Mechanische Versuchsanstalt Max Grundig & Co. KG., Kurgartenstrasse 37, D-8510 Fürth (DE)**

(72) Erfinder: **Bodo, Fritz, Hüttendorfer Weg 28, D-8510 Fuerth/Bay (DE)**
Erfinder: **Gärtner, Eduard, Auf der Lüss 44, D-8431 Sengenthal (DE)**
Erfinder: **Nohse, Dieter, Buchenstrasse 18, D-8501 Seukendorf (DE)**

(74) Vertreter: **Kolb, Max, Kurgartenstrasse 37, D-8510 Fuerth/Bayern (DE)**

(54) **Kombinationsgerät aus Rundfunkgerät und mindestens einem zusätzlichen elektronischen Gerät.**

(57) Bei einem Kombinationsgerät aus Rundfunkgerät (4) und mindestens einem zusätzlichen elektronischen Gerät mit Sichtanzeige (3) für einstellbare Daten, die über einen Mikrocomputer (1) gesteuert und gespeichert werden, steht der Mikrocomputer zusätzlich über einen Analog-Digital-Converter (ADC) (2) mit mehreren Klima-Sensoren (10, 11, 12, 13) und über Steuerleitungen (20, 21, 22) mit einer Tastatur (8) in Verbindung. Durch die Tastatur (8) wird ein gewünschtes Sensorsignal über die zum ADC (2) führenden Kontrolleitungen (14) vom Mikrocomputer abgegriffen, verarbeitet und als Meßwert angezeigt.

EP 0 123 729 A1

# KOMBINATIONSGERÄT AUS RUNDFUNKGERÄT UND MINDESTENS EINEM ZUSÄTZLICHEN ELEKTRONISCHEN GERÄT

BESCHREIBUNG:

Die Erfindung betrifft ein Kombinationsgerät aus Rundfunkgerät und mindestens einem zusätzlichen elektronischen Gerät mit Sichtanzeige für einstellbare und abrufbare Daten, die über einen Mikrocomputer gesteuert und gespeichert werden.

Es ist eine elektronische Meß- und Anzeigevorrichtung bekannt, die es einem Benutzer ermöglicht, sich laufend über Innen- und Außentemperatur sowie den Luftdruck zu informieren. Innen- und Außentemperatur werden dort nacheinander im zeitlichen Wechsel numerisch auf einer LED-Anzeige dargestellt. Die Information über den Luftdruck hat qualitativen Charakter und bezieht sich insbesondere auf die augenblickliche Luftdrucktendenz (Funkschau 1/1983, Seite 90).

Die Nachteile der bekannten Wetterstation bestehen einerseits in der fehlenden numerischen Anzeige des Luftdruckes und in der fehlenden Information über die bestehenden Luftfeuchtigkeitsverhältnisse. Andererseits ist das bekannte Gerät aufwendig aufgebaut und im Hinblick auf den Platzbedarf für viele Anwendungsfälle nicht einsatzfähig.

Der Erfindung liegt deshalb die Aufgabe zugrunde, ein raumsparendes und kostengünstiges Gerät für eine Wetterstation zu schaffen, bei dem bereits vorhandene elektronische Einrichtungen verwendet werden und das dem Benutzer eine vollständige Information über die bestehenden inneren und äusseren klimatischen Verhältnisse ermöglicht. Dabei sollen alle interessierenden Daten des Gerätes zentral von einem ohnehin vorhandenen Mikrocomputer gesteuert und auf einem Display angezeigt werden.

Diese Aufgabe wird bei einem Kombinationsgerät der im Oberbegriff des Anspruches 1 bezeichneten Art durch die im kennzeichnenden Teil des Anspruches 1 angegebenen Merkmale gelöst. Vorteilhafte Weiterbildungen der Erfindung sind in den Unteransprüchen gekennzeichnet.

Ein Ausführungsbeispiel der Erfindung ist im folgenden anhand von Zeichnungen näher erläutert. Es zeigen:

Fig. 1        ein Blockschaltbild mit den wichtig-
              sten Funktionsblöcken eines erfin-
              dungsgemäßen Kombinationsgerätes.

Fig. 2 a-k    einige konkrete Anzeigebeispiele von
              Meß- und/oder Funktionsdaten dieses
              Kombinationsgerätes auf einem geeignet gestalteten Display.

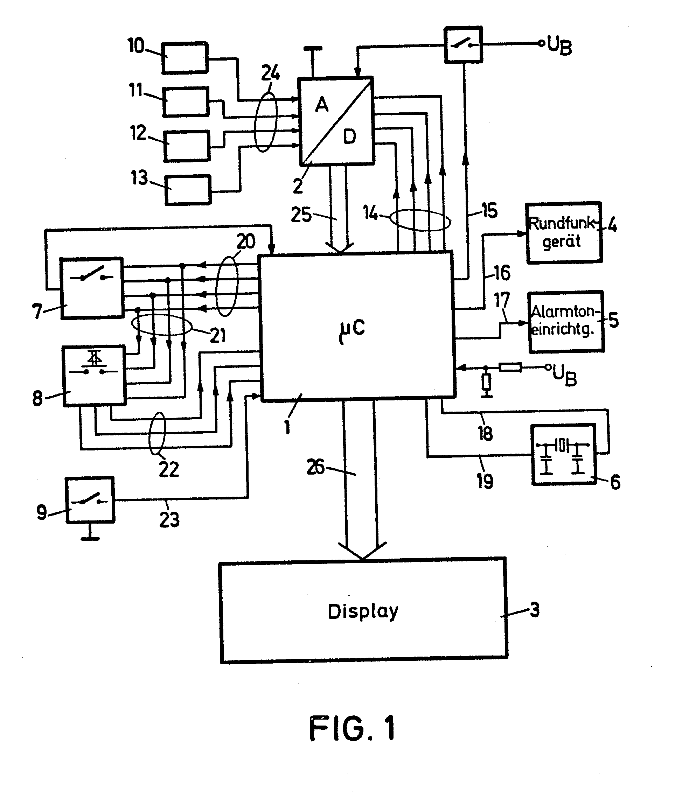

In der Blockschaltung der Fig. 1 bildet ein Mikrocomputer 1 die zentrale Verarbeitungs- und Steuereinheit der dargestellten Anordnung. Er ist über mehrere Steuerleitungen 20 mit einem Betriebsartenschalter 7 verbunden. Parallel zum Betriebsartenschalter 7 ist an die Steuerleitungen 20 das von einer Tastatur 8 kommende Leitungsbündel 21 angeschlossen. Ein weiteres Leitungsbündel 22 verbindet mehrere Steuereingänge des Mikrocomputers 1 ebenfalls mit der Tastatur 8, die derart ausgebildet ist, daß jede Einzelleitung des Bündels 21 mit jeder beliebigen Einzelleitung des Bündels 22 verbunden und wieder getrennt werden kann. Über die Steuerleitung 23 ist ein weiterer Schalter 9 an den Mikrocomputer angeschlossen. Mittels der Schalt- und Tasteinheiten 7, 8 und 9 können alle Befehle, welche die übrige Peripherie des Mikrocomputers 1

betreffen, an den Mikrocomputer abgegeben werden, der diese dann geeignet verarbeitet, gegebenenfalls speichert und an die entsprechenden Einrichtungen weiterleitet. Zu diesen Einrichtungen, welche durch entsprechende Leitungen 16, 17, 18 und 19 mit dem Mikrocomputer 1 in Verbindung stehen, gehören unter anderem ein Rundfunkgerät 4, eine Alarmtoneinrichtung 5 und eine Einrichtung 6, mittels der der Mikrocomputer eine elektronische Zeitmessung durchführt. Weiterhin sind zu verschiedenen Meßzwecken vier Klima-Sensoren 10, 11, 12 und 13 mit den Leitungen 24 an einen Analog-Digital-Converter (ADC) 2 angeschlossen, der die einzelnen Meßdaten in digitaler Form über die Leitung 25 an den Mikrocomputer 1 weitergibt. Dieser ist darüber hinaus durch mehrere Kontrolleitungen 14 mit dem ADC verbunden. Eine Leitung 15 steuert eine Schalteinrichtung zur Spannungsversorgung des Analogteiles. Als Sichtanzeige wird ein über die Leitungen 26 mit dem Mikrocomputer 1 gekoppeltes Multifunktions-Display verwendet.

Bei einer derartigen Schaltungsanordnung eines erfindungsgemäßen Kombinationsgerätes können unabhängig von der gewählten Betriebsart mittels der Tastatur 8 zu jeder Zeit alle numerischen Meßdaten der angebauten Wetterstation über den Mikrocomputer 1 abgerufen und auf dem Multifunktions-Display 3 zur Anzeige gebracht werden. Als Meßfühler für die Messung der Außen- und Innentemperatur, des Luftdruckes und der Luftfeuchtigkeit sind mehrere verschiedene Klima-Sensoren 10 bis 13 vorhanden, die entweder in das Gerät integriert oder extern daran angeschlossen werden. Über die Leitungen 24 gelangen die von ihnen gelieferten analogen Signale auf den Eingang des Analog-Digital-Converters (ADC) 2. Der Mikrocomputer 1 greift nun zum einen selbständig und zum anderen veranlaßt durch die Betätigung der entsprechenden Tastenelemente der Tastatur 8 über die Kontrolleitungen 14 auf die interessierenden Meßsignale zu. Diese werden dann in digitaler Form über die Leitung 25 dem Mikrocomputer 1 zugeführt und dort verarbeitet. Die Dauer der darauf folgenden Anzeige auf dem Multifunktions-Display 3 des jeweils interessierenden Meßwertes entspricht, abgesehen von einer bestimmten Verzögerungszeit nach dem Öffnen des betreffenden Tastelementes, der Zeitspanne, in der das Tastelement gedrückt bleibt. Neben der numerischen Anzeige der Meßwerte auf Abruf über die Tastatur 8 erscheint für den Luftdruck und dessen Tendenz auf dem Display eine zusätzliche symbolische Anzeige, die automatisch auch während der normalerweise vorhandenen Tageszeit-Anzeige erfolgt. Hierzu greift der Mikrocomputer selbständig in regelmäßigen Zeitabständen auf die für diese Anzeige erforderlichen Meßwerte zu und bestimmt aus mehreren aufeinanderfolgenden Werten eine steigende, gleichbleibende oder fallende Luftdrucktendenz. Die Höhe des Luftdruckes wird qualitativ durch drei Symbole bzw. Symbolkombinationen ausgedrückt, die jeweils einen bestimmten Luftdruckbereich verkörpern. Werden bestimmte einstellbare Grenzen von Meßwerten der einzelnen Klima-Sensoren über- oder unterschritten, dann wird über den Mikrocomputer 1 die Alarmtoneinrichtung 5 ausgelöst.

Darüber hinaus kann mittels der Schalteinheit 7 über den Mikrocomputer 1 eine zusätzlich gewünschte Betriebsart gewählt und symbolisch auf dem Multifunktions-Display angezeigt werden. Je nach Schalterstellung ist es möglich, die beschriebene Anordnung beispielsweise als normales Rundfunkgerät oder aber als Weckeinrichtung zu betreiben. Die vom jeweiligen Benutzer bevorzugte Weckart, ob über Radio oder einen Alarmton, ist ebenfalls durch die Schalteinheit 7 einstellbar. Mittels entsprechender Tastenelemente der

0123729

-7-

Tastatur 8 werden die gewünschten Weckzeiten
in den Mikrocomputer eingespeichert und dort
mit der vom Mikrocomputer und der Einrichtung
6 bestimmten Realzeit verglichen. Bei einer
Übereinstimmung gibt der Mikrocomputer 1 einen
Schaltbefehl zur Aktivierung der vorher mit dem
Schalter 7 gewählten Weckeinrichtung. Durch ein
weiteres Tastenelement der Tastatur 8 ist es
möglich, die in Gang gesetzte Weckeinrichtung
für einen kurzen begrenzten Zeitraum zu unterbrechen. Nach dem Verstreichen des Zeitraumes
erfolgt eine Weckwiederholung. Eine zusätzliche
Schlummerfunktion erlaubt unabhängig von der erläuterten Weckfunktion das Einschalten des Rundfunkteils für eine wählbare begrenzte Zeitdauer.
Nach Ablauf dieser Schlummerzeit wird der Rundfunkteil wieder außer Betrieb gesetzt. Mit Hilfe des Schalters 9 kann eine Umschaltung von
Winter- auf Sommerzeit bzw. umgekehrt erfolgen.

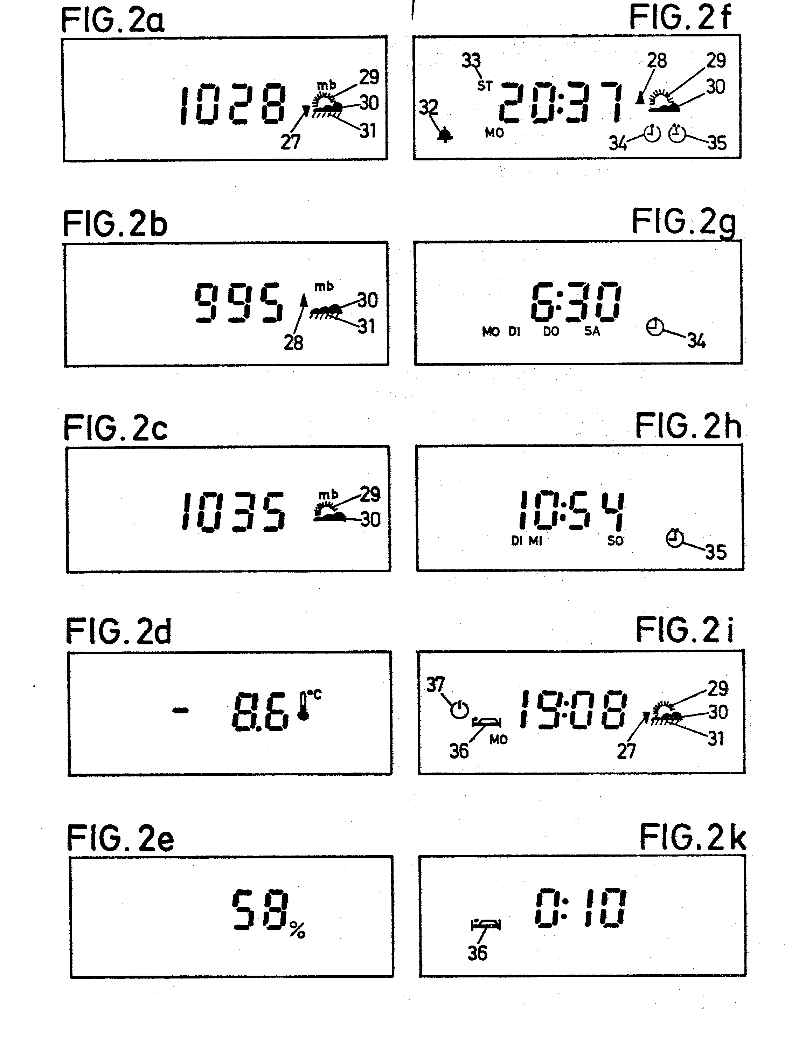

Die Figuren 2a bis k zeigen einige konkrete Anzeigebeispiele auf einer geeigneten Sichtanzeige
zur Darstellung und Symbolisierung der zu messenden und anzuzeigenden Größen und Betriebsarten.

Die Figuren 2a, b und c stellen Beispiele für
eine Luftdruckanzeige dar. Eine derartige Anzeige

- 8 -

erscheint auf Abruf über die Tastatur 8 unabhängig von der gewählten Betriebsart. Neben dem jeweiligen Zahlenwert in Millibar geben die Symbole 27 und 28 an, ob der momentan angezeigte Luftdruck im Hinblick auf einen begrenzten zurückliegenden Zeitraum eine fallende oder steigende Tendenz aufweist. Leuchtet keines der beiden Symbole (vgl. Fig. 2c), so ist der Luftdruck gleichbleibend. Die Symbole 29, 30 und 31 geben qualitativ Auskunft über die Höhe des Luftdruckes. Hierbei stehen die Symbole 30 und 31 für einen Luftdruckbereich unterhalb 998 Millibar, wogegen die Symbole 29 und 30 in einem Luftdruckbereich über 1030 Millibar zur Anzeige kommen. Im Bereich zwischen 998 und 1030 Millibar tauchen alle drei Symbole 29, 30 und 31 in der Sichtanzeige auf.

Die Figuren 2d und 2e sind Beispiele für die Anzeige einer negativen Außentemperatur von -8,6° C und einer z.B. in einem Zimmer herrschenden relativen Luftfeuchtigkeit von 58%. Beide Anzeigen erscheinen jeweils bei Betätigung der

-12-

entsprechenden Tastenelemente der Tastatur 8 unabhängig von der gewählten Betriebsart.

Die in der Fig. 2f dargestellte Anzeige weist durch das Symbol 32 auf die Betriebsart "Wecken mittels Alarmton" hin. Bei diesem Anzeigebeispiel ist kein Tastenelement der Tastatur 8 gedrückt, und es erscheint als Anzeige der Wochentag und die dazugehörige Uhrzeit, hier Montag, 20 Uhr 37, und zusätzlich mit dem Symbol 33 der Hinweis, daß es sich um eine Sommerzeitangabe handelt. Daneben informieren die Symbole 28, 29 und 30 über eine steigende Luftdrucktendenz und eine Höhe des Luftdruckes von größer 1030 Millibar. Darüber hinaus wird durch die Symbole 34 und 35 daran erinnert, daß sich innerhalb eines bevorstehenden Zeitraumes (z.B. 24 Stunden) zwei Weckzeiten befinden, bei denen die Alarmtoneinrichtung in Aktion tritt.

Die genauen Weckzeiten können über die Tastatur 8 abgerufen werden. Die daraufhin erscheinenden möglichen Anzeigen sind als Beispiele in den Figuren 2g und 2h dargestellt. Hieraus ist zu entnehmen, daß die erste Weckzeit, die durch das Symbol 34 angekündigt wird, auf Montag, Dienstag, Donnerstag und Samstag jeweils um 6 Uhr 30, während die durch das Symbol 35 angekündigte Weckzeit jeweils auf Dienstag, Mittwoch und Sonntag um 10 Uhr 54 gelegt wurde.

Soll keine der festgelegten Weckzeiten in Anspruch genommen werden und ist kein Betrieb der Anordnung z.B. als normales Rundfunkgerät erwünscht, dann wird der Betriebsartenschalter in eine entsprechende Stellung gebracht. Dies wird auf der Anzeige in der Fig. 2i durch das Symbol 37 zum Ausdruck gebracht. In dem vorliegenden Betriebszustand wird dann der Wochentag und die dazugehörige Tageszeit, hier Montag, 19 Uhr 8, angezeigt. Außerdem erscheint die symbolische Anzeige über die zu dieser Zeit bestehenden Luftdruckverhältnisse. Im betrachteten Beispiel ist die Luftdrucktendenz fallend (Symbol 27) und die qualitative Anzeige des Luftdruckes (Symbole 29, 30 und 31) läßt auf einen Luftdruck innerhalb des Bereiches 998 bis 1030 Millibar schließen. Weiterhin ist mit dem Symbol 36 aus der Anzeige ersichtlich, daß die Schlummerfunktion aktiviert wurde und das Rundfunkgerät bis zum Ablauf der Schlummerzeit eingeschaltet bleibt.

Der zur Verfügung stehende Schlummer-Zeitraum kann ebenfalls über die Tastatur 8 abgerufen werden. Ein Beispiel zeigt die Fig. 2k, aus der durch das Symbol 36 die Schlummerfunktion und ferner der zur Verfügung stehende Schlummer-Zeitraum von z.B. 10 Minuten zu erkennen sind.

KOMBINATIONSGERÄT AUS RUNDFUNKGERÄT UND MINDESTENS
EINEM ZUSÄTZLICHEN ELEKTRONISCHEN GERÄT

PATENTANSPRÜCHE:

1. Kombinationsgerät aus Rundfunkgerät und mindestens einem zusätzlichen elektronischen Gerät mit Sichtanzeige für einstellbare und abrufbare Daten, die über einen Mikrocomputer gesteuert und gespeichert werden, dadurch gekennzeichnet, daß der Mikrocomputer (1) einerseits über einen Analog-Digital-Konverter (2) mit mehreren Klima-Sensoren (10,11,12,13) und andererseits über Steuerleitungen (20,21,22,23) mit einer Tastatur (7,8,9) verbunden ist, bei deren Betätigung ein gewünschtes Sensorsignal über Kontrolleitungen (14), die zum Analog-Digital-Konverter führen, vom Mikrocomputer abgegriffen, verarbeitet und als Meßwert angezeigt wird.

2. Kombinationsgerät nach Anspruch 1, dadurch gekennzeichnet, daß zusätzlich zur qualitativen Anzeige der Klima-Meßwerte der Tendenzverlauf dieser Werte symbolisch angezeigt wird, der mittels der Klima-Sensoren (10,11,12,13) über den Mikrocomputer (1) aus den innerhalb eines vorgegebenen Zeitraumes ermittelten Klima-Messwerten
abgeleitet wird.

3. Kombinationsgerät nach Anspruch 2, dadurch gekennzeichnet, daß der Mikrocomputer (1)
mit einer Einrichtung (6) verbunden ist, mittels
der er eine elektronische Zeitmessung zur Ermittlung des Tendenzverlaufes der Klima-Meßwerte
durchführt.

4. Kombinationsgerät nach Anspruch 3, dadurch gekennzeichnet, daß über die Einrichtung
(6) zur elektronischen Zeitmessung und den mit ihr
verbundenen Mikrocomputer (1) zugleich die Uhrzeit oder wahlweise eine der Weckzeiten angezeigt
wird.

5. Kombinationsgerät nach Anspruch 3 oder
4, dadurch gekennzeichnet, daß der Mikrocomputer
(1) mit einer Alarmtoneinrichtung (5) verbunden
ist, die beim Über- bzw. Unterschreiten bestimmter Grenzen der Klima- und Zeitwerte über den Mikrocomputer ausgelöst wird.

6. Kombinationsgerät nach einem oder mehreren der Ansprüche 1 bis 5, dadurch gekennzeichnet,
daß die Klimasensoren (10,11,12,13) zur Messung

-3-

von Innentemperatur, Außentemperatur, Luftdruck und Luftfeuchtigkeit dienen und dementsprechend außerhalb oder innerhalb des Kombinationsgerätes angeordnet sind.

-4-
Beschreibung:

Reg. 1905
0123729

FIG. 1

2/2

## FIG.2a

1028 mb — 29
— 30
27 — 31

## FIG.2f

33 ST 20:37 28 — 29
— 30
32 ⏰
MO 34 ⏰ ⏰ — 35

## FIG.2b

995 mb — 30
28 — 31

## FIG.2g

6:30
MO DI DO SA ⏰ — 34

## FIG.2c

1035 mb — 29
— 30

## FIG.2h

10:54
DI MI SO ⏰ — 35

## FIG.2d

- 8.6 °C

## FIG.2i

37 ⏰ 19:08 — 29
36 MO 27 — 30
— 31

## FIG.2e

58 %

## FIG.2k

0:10
36

## EINSCHLÄGIGE DOKUMENTE

EP 83112604.0

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| X | <u>US - A - 4 287 762</u> (BAER)<br><br>* Fig. 1; Spalte 3, Zeile 19 - Spalte 5, Zeile 5; Spalte 8, Zeilen 38-55 * | 1,6 | G 01 W 1/04<br><br>H 05 K 11/00 |
| A | -- | 2,3 | |
| X | <u>US - A - 4 295 139</u> (ARPINO)<br><br>* Fig. 1; Spalte 6, Zeile 26 - Spalte 7, Zeile 16 * | 1 | |
| A | -- | 3 | |
| A | ELEKTRONIK, Jahrgang 1981, Heft 18, 11. September 1981, München<br><br>U. KNÜPFER "Klimastation erfaßt 16 Parameter"<br>Seiten 104-108<br><br>* Seite 105, Bild 1 * | 1,3,4 | |
| | -- | | **RECHERCHIERTE SACHGEBIETE (Int. Cl. ³)**<br><br>G 01 W 1/00<br>H 05 K 11/00 |
| D,A | FUNKSCHAU, Jahrgang 1983, Heft 1, 7. Jänner 1983, München<br><br>"Der "Wetterfrosch" auf dem Schreibtisch"<br>Seite 90<br><br>* Gesamt * | 1,2 | |
| A | <u>DD - A - 155 559</u> (AKADEMIE)<br><br>* Fig.; Zusammenfassung * | 3 | |
| A | <u>AT - B - 370 245</u> (BOSCHUNG)<br><br>* Seite 4, Zeilen 22-24 *<br><br>---- | 5 | |

Der vorliegende Recherchenbericht wurde für alle Patentansprüche erstellt.

| Recherchenort | Abschlußdatum der Recherche | Prüfer |
|---|---|---|
| WIEN | 11-07-1984 | BURGHARDT |